# EUROPEAN PATENT APPLICATION

(11) **EP 1 802 187 A2**
(43) Date of publication of application: **27.06.2007**
(21) Application number: 06123432.4
(22) Date of filing: 03.11.2006
(51) Int. Cl.: H05K 3/46

(54) **Printed circuit board and manufacturing method thereof**

(30) Priority: 26.12.2005 CN 200510003594
(71) Applicant: High Tech Computer Corp., Taoyuan City, Taoyuan Hsien (TW)
(72) Inventor: Ho, Chin-Wei, Taoyuan Hsien, Taoyuan City (TW)
(74) Representative: Schwabe - Sandmair - Marx

(57) **Abstract**

A printed circuit board and manufacturing method thereof is disclosed. First, a conductive layer disposed on an insulation layer is provided. The conductive layer is patterned to form at least a conductive layer opening and the insulation layer is drilled throughout to form a via at a position corresponding to the conductive layer opening. The via is then loaded with a conductive material. A plurality of substrates are formed through the steps above and are bonded to form a multi-layer printed circuit board.

## Description

### BACKGROUND OF THE INVENTION

### Field of Invention

The invention relates to a printed circuit board (PCB) and the manufacturing method thereof. In particular, it relates to a multi-layer PCB with shared conductive pads and the method of manufacturing the same.

### Related Art

The PCB is a circuit board that supports electronic devices with a circuit design on an insulator, through the steps of patterning the circuit layout and specific machining and processing. The present invention is to let the onboard electronic devices function normally.

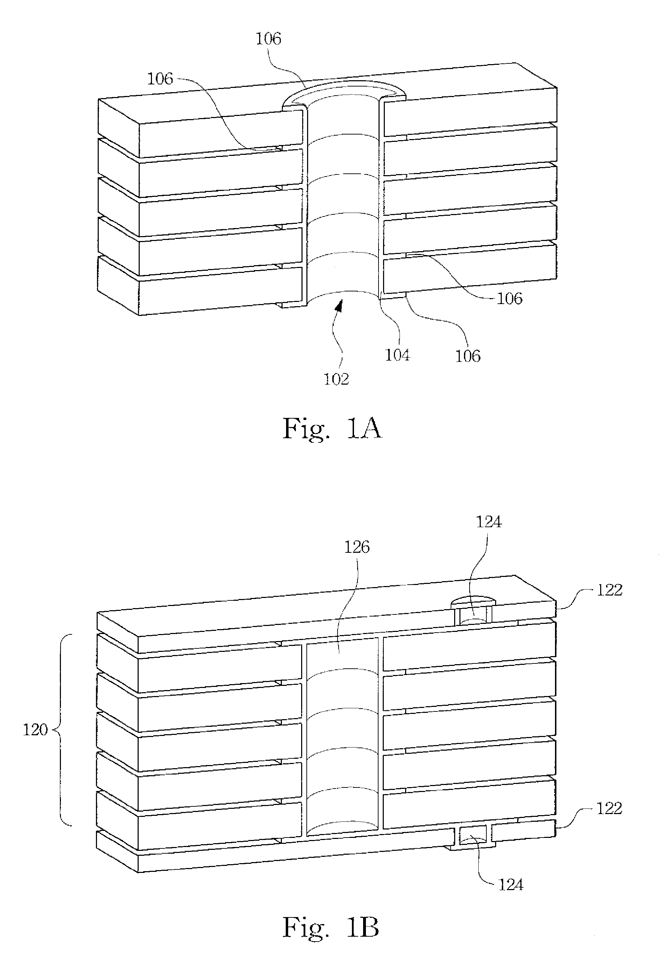

In the existing multi-layer PCB manufacturing process, vias are created using different methods. For example, the layers of the PCB can be mechanically drilled all at once. That is, the holes are formed by drilling through the resin layers, such as the phenolic or epoxy, along with copper foils. FIG. 1A shows the cross-sectional view of a multi-layer PCB that is drilled through using a traditional drilling head. In the drawing, the connections between the layers are achieved by stacking several boards, followed by drilling holes through the stack at predetermined positions to form the vias 102, which are also called the plated through hole (PTH). Afterwards, plating is used to form a conductive film 104 on the wall of the via. The different layers are connected using pads 106 and conductive copper films 104. That is, the conventional multi-layer PCB is manufactured by a single pressing, followed by drilling, plating, and circuit etching.

As shown in FIG. 1B, another conventional method of adding layers is to first form base vias 126 using conventional mechanical drilling for the base layers 120. The vias 124 of the outermost, i.e. the upper and lower, additional layers 122 are formed by laser drilling, before pressing them to the base layers 120. This forms a multi-layer structure with non-through holes. However, it is impossible to prevent unnecessary through holes from being produced on the base layers. Both the above-mentioned two production methods in the prior art use mechanical drilling. The diameter of the drilled holesare larger. The needed pad size also inevitably occupies a larger area on each layer.

In view of the miniaturization trend of electronic products, efficient use of the limited PCB layer area is an important technical issue. If the diameters cannot be decreased, the layout space on the board will become very restricted. One-time drilling to form a through hole in all the stacked boards is also a cost in the configuration of the pads. This is because each board layer has to be provided with a pad in order to connect different layers. However, unless several layers should be connected with one another, the drilling through method wastes circuit space in other layers and results in signal interference.

### SUMMARY OF THE INVENTION

One aspect of the invention is to provide a PCB and the manufacturing method thereof for obtaining a smaller pad size than conventional mechanical drilling methods.

Another aspect of the invention is to provide a PCB and the manufacturing method thereof for preventing unnecessary drilling and increasing the layout area.

A further aspect of the invention is to provide a PCB and the manufacturing method thereof for achieving the pad design data sharing and effectively saving the layout time.

In accord with the above aspects, the disclosed PCB manufacturing method includes: providing a conductive layer deposited on an insulation layer; patterning the conductive layer and forming at least one conductive layer opening; drilling at the conductive layer opening through the insulation layer and forming a via; introducing a conductive material in the via; and repeating the above-mentioned steps for forming a plurality of layers, and bonding the layers together. At least one conductive layer opening is located at a position normal to the board that is not perpendicular to its adjacent conductive layer opening.

According to a preferred embodiment of the invention, the copper clad laminate (CCL) is used as the material for each layer. The center substrate contains an insulation layer and two copper foils on the upper and lower sides thereof. A circuit is patterned on the center substrate and the copper foil layer of an additional substrate. A copper foil opening is formed at a predetermined via. A carbon dioxide laser drills a hole on the insulation layer at the copper foil opening, forming a via. Finally, the center substrate and the additional substrate are bonded together. The rest of the additional substrates are further bonded thereon as needed.

Another embodiment of the invention is a PCB with a center substrate and at least one additional substrate. The center substrate has a center insulation layer connected to a center conductive layer. The center insulation layer has a center via. The additional substrate has an additional insulation layer and an additional conductive layer. The additional insulation layer is sandwiched between the center conductive layer and the additional conductive layer and has an additional via. The center via and the additional via are loaded with a conductive material. An axis of the center via and an axis of the additional via are separated by a predetermined distance and are electrically coupled via the additional conductive layer and the conductive material.

A further embodiment of the invention is a portable electronic device comprising a display unit, a control unit, and an input unit. The control unit includes an arbitrary via circuit board structure of the invention. The disclosed circuit board is applied to a portable electronic device, such as a mobile phone.

According to the disclosed manufacturing method of the PCB, the via at an arbitrary position in the multi-layer structure can be formed using existing processes and equipment without any special arrangement. Therefore, this not only reduces the formation of unnecessary through holes, but increases the available layout area. The circuit design personnel does not need to produce a different file data for different processes based on the prior art. A design with file data sharing is used instead. That is, different PCB processes can share the PCB circuit layout file data and the layout file data format in order to avoid complications and satisfying many more electronic circuit design requirements.

### BRIEF DESCRIPTION OF THE DRAWINGS

These and other features, aspects and advantages of the invention will become apparent by reference to the following description and accompanying drawings which are given by way of illustration only, and thus are not limitative of the invention, and wherein:
FIG. 1A is a schematic cross-sectional view of the circuit board structure formed using conventional mechanical drilling;
FIG. 1B is a schematic cross-sectional view of the circuit board structure formed using the conventional layer addition method;
FIG. 2 is a flowchart of the PCB manufacturing method according to a preferred embodiment of the invention;
FIG. 3A is a schematic cross-sectional view of the layers of substrates before bonding in a preferred embodiment of the invention;
FIG. 3B is a schematic cross-sectional view of the layers of substrates after bonding in the preferred embodiment of the invention; and
FIG. 4 is a schematic view of using the disclosed PCB in a portable electronic device.

### DETAILED DESCRIPTION OF THE INVENTION

The present invention will be apparent from the following detailed description, which proceeds with reference to the accompanying drawings, wherein the same references relate to the same elements.

The invention discloses a PCB and the manufacturing method thereof. Its sharing pad design is suitable for different multi-layer circuit board processes. By drilling and bonding layer by layer, the invention achieves the goals of forming a through hole at an arbitrary position in the multi-layer structure and reducing unnecessary wasted space caused by the through hole.

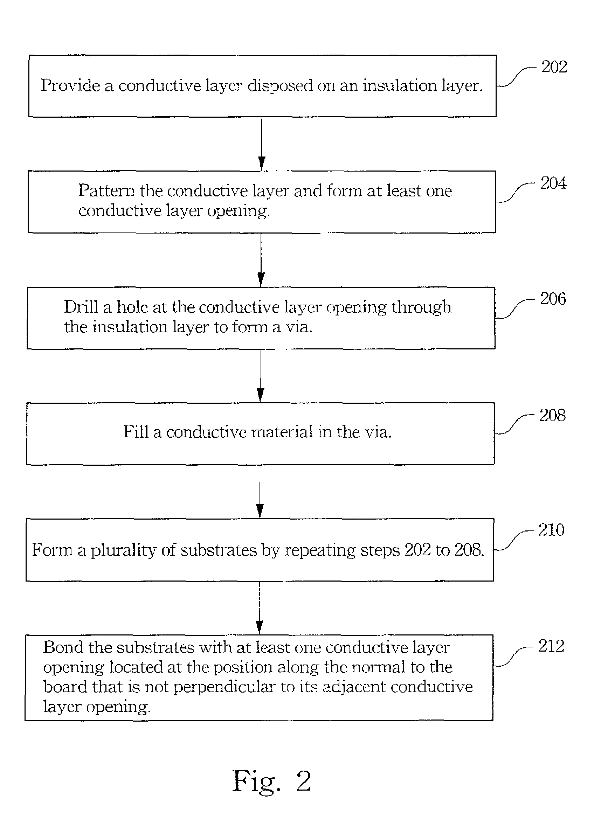

With reference to FIG. 2, the disclosed PCB manufacturing method includes the following steps. First, a conductive layer deposited on an insulation layer is provided. The conductive layer is patterned and formed with at least one conductive layer opening. The conductive layer opening is drilled through the insulation layer, forming a via. The via is loaded with a conductive material. A plurality of substrates are formed using the above steps and bonded according to the design. At least one conductive layer opening is formed at a position along the normal to the board that is not perpendicular to its adjacent conductive layer opening.

In this embodiment, each layer uses a conventional CCL. That is, one or both surfaces of each insulation layer are covered with copper foils. The copper foil is the conductive layer to be patterned. The insulation layer contains phenolic or epoxy, called the resin substrate. In step 202, a center insulation layer and a center copper foil layer are provided first. The center copper foil layer is a conductive layer that is bonded with the central insulation layer in advance.

In step 204, a desired circuit pattern is defined on the center copper foil layer. That is, the center copper foil layer is patterned according the circuit blueprint, forming a necessary circuit structure. The patterning includes forming at least one center copper foil opening. The center copper foil opening is used for forming the center via in the subsequent drilling step.

In step 206, the center copper foil opening is drilled through the center insulation layer, forming at least one center via. The drilling method can be conventional mechanical drilling or laser drilling, which can render an opening with a smaller diameter. The laser drilling may be done with a carbon dioxide laser. Afterwards, chemical plating fills the center via with a conductive material, preferably copper, thereby connecting layers.

In step 208, the center via is loaded with a conductive material to provide an electrical connection. Finally, a center substrate is obtained by electroplating or other deposition methods. In step 210, a first additional substrate is prepared following the above-mentioned steps 202 to 208. In step 212, the first additional substrate is bonded with the center substrate.

In this embodiment, the conducting circuit between the additional layer and the center layer follows a predetermined design. When preparing the center substrate, a circuit is patterned on the layer copper foil in the center. Additional substrates are prepared according to the design (step 210). The center substrate is then bonded with additional substrates to render a multi-layer PCB (step 212).

The above describes an example of bonding the substrates layer by layer. However, one may also first prepare all the substrates and then bond them together all at once. Although the above-mentioned manufacturing procedure is described for only one center substrate and one additional substrate, the center substrate may already be one with multi-layer substrates. It can be mechanically drilled to form vias and electroplated and then bonded with additional substrates using the disclosed method. The invention is not restricted to the case where each layer of substrate has to be laser drilled to form individual vias, followed by electroplating and bonding. Such variations can be readily performed by a person skilled in the art.

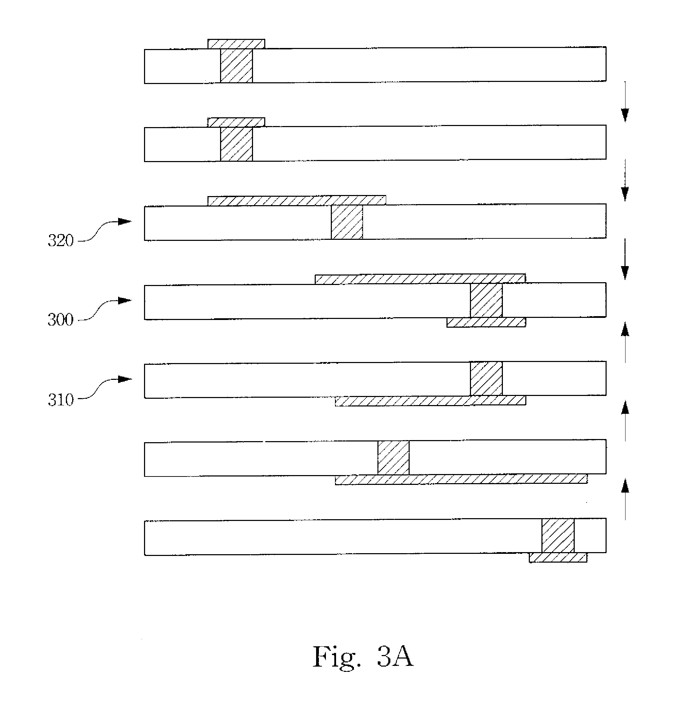

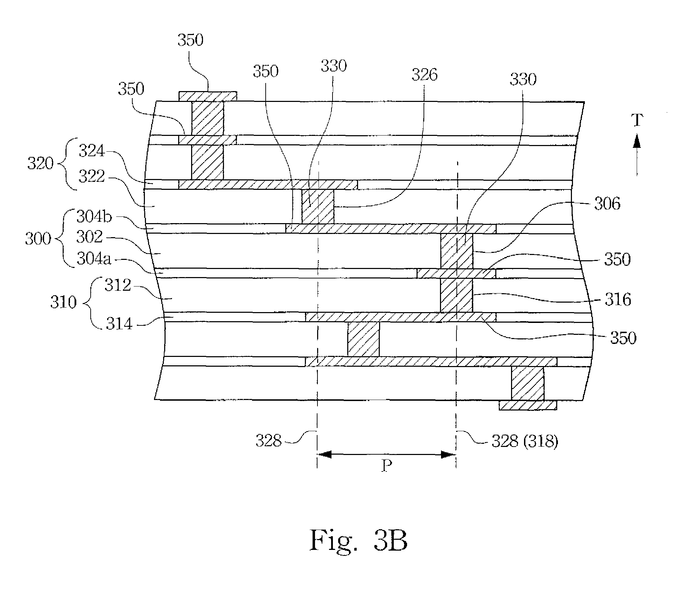

With simultaneous reference to FIGS. 3A and 3B, another embodiment of the invention is a PCB structure that contains a center substrate 300 and at least one additional substrate 310. The center substrate 300 contains a center insulation layer 302 connected to a center conductive layer 304b. The center insulation layer 302 has a center via 306.

The additional substrate 320 contains an additional insulation layer 322 and an additional conductive layer 324. The additional insulation layer 322 is disposed between the center conductive layer 304b and the additional conductive layer 324. The additional insulation layer 322 has an additional via 326. The center via 306 and the additional via 326 are loaded with a conductive material 330. The axis 308 of the center via 308 and the axis 328 of the additional via are separated by a predetermined distance P. They are electrically coupled through the center conductive layer 304b and the conductive material 330.

In a preferred embodiment, the circuit board is a PCB with eight layers of circuits. It includes a center substrate and six additional substrates. FIG. 3A or 3B clearly shows that the center substrate 300 includes a center insulation layer and two center conductive layers disposed and pre-bonded above and below the center insulation layer before further bonding. Each additional substrate 310 or 320 includes an additional insulation layer and an additional conductive layer. The conductive layer uses the copper foil in this embodiment.

The center substrate 300 includes a center insulation layer 302, a first center conductive layer 304a and a second center conductive layer 304b. The first center conductive layer 304a is bonded to the lower surface of the center insulation layer 302. The second center conductive layer 304b is bonded to the upper surface of the center insulation layer 302. The center insulation layer 302 is formed with a center via 306. The two conductive layers are formed with predetermined circuits.

If each via is formed by laser drilling, the size of the pad 350 thereon may be as small as or smaller than approximately 10mm. Each via is formed with copper 330 by electroplating to achieve electrical conduction. The conductive material 330 inside the via can be formed using some other deposition method.

A first additional layer 310 is bonded to the lower surface of the first center conductive layer 304a. The first additional layer 310 includes a first additional insulation layer 312 and a first additional conductive layer 314. The first additional insulation layer is disposed between the first center conductive layer 304a and the first additional conductive layer 314 and formed with a first additional via 316.

The first additional via 316 and the center via 306 are at roughly at the same position along the normal to the board T. That is, the axis 318 of the first additional via 318 and the axis 308 of the center via are roughly the same. Therefore, if the via diameter requirement is not strict in this embodiment, the center substrate 300 and the first additional substrate 310 can be bonded first, followed by traditional mechanical drilling. There is no need to perform laser drilling individually before bonding them together.

The second additional substrate 320 is bonded on the upper surface of the second center conductive layer 304b. The second additional substrate 320 includes a second additional insulation layer 322 and a second additional conductive layer 324. The second additional insulation layer 322 is disposed between the second center conductive layer 304b and the second additional conductive layer 324 and formed with a second additional via 326. The second additional via 326 and the center via 306 are at different positions along the normal to the board T. That is, the axis 328 of the second additional via and the axis 308 of the center via are separated by a predetermined distance P.

Each of the above-mentioned conductive layers is patterned first. The drawings have been simplified from the actual circuit board structure. Each insulation layer has only one via in them. Moreover, each conductive layer only displays the pad and the related connection, emphasizing that the disclosed connection design does not need to be the same as in the prior art of drilling holes at the corresponding position on each substrate. The holes are formed only at specific, necessary layers. Therefore, the layout area on each layer is increased.

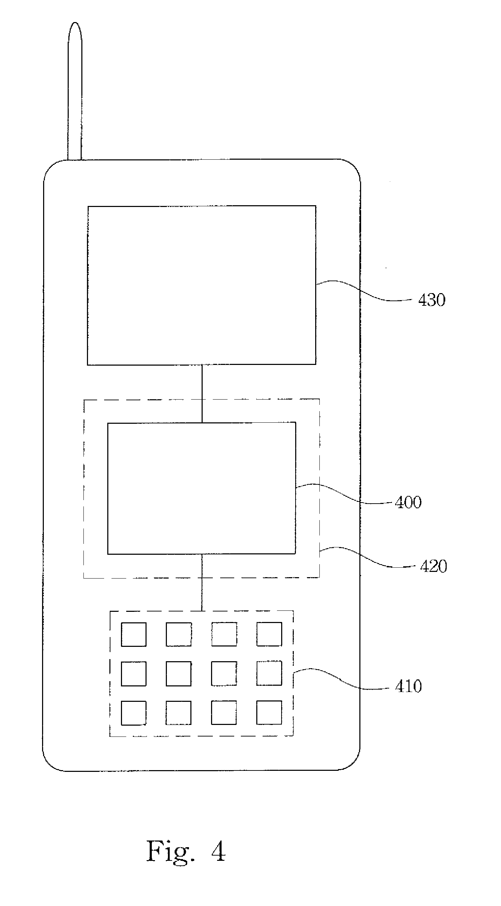

FIG. 4 is a schematic view of the disclosed PCB in a portable electronic device, such as a mobile phone. The electronic device includes a display unit 430, a control unit 420, and an input unit. The control unit 420 includes the circuit board structure 400 with an arbitrary via according to the invention, e.g. the circuit board structure in FIG. 3B.

The input unit 410 can be, for example, a key set for entering an input signal. The input signal is transmitted via the circuit board structure and processed by a device on the control unit 420, such as a chip (not shown). The display unit 430 can be, for example, a liquid crystal display (LCD) panel. An image responds to the input signal. It should be noted that the circuit layout of the arbitrary via circuit board 400 and the devices thereon have not be shown in order to emphasize the characteristic of an arbitrary via position in the invention.

According to the above-mentioned preferred embodiment, the invention has the following advantages. The PCB is patterned according to a circuit layout. Before drilling holes in each layer of substrate, copper foil openings are patterned for subsequent hole drilling. Therefore, vias can be formed in the insulation layer by direct laser drilling, rendering small holes. This further reduces the size and cost of pads.

According to the invention, the position of the via in each layer can be arbitrarily selected. It is not restricted to one drilling through all the substrates. The available layout area is also increased. Therefore, the invention provides a breakthrough in the technical development of device integration and miniaturization.

Besides, the sizes of pads are different in various kinds of multi-layer manufacturing processes in the prior art. The circuit designer has to produce different data files for different processes using, for example, the commonly seen layout file format. The invention can be implemented using existing processes without employing any other special process. It can be applied to soft, hard, and combined PCB's. With the shared data file, the pads on the circuit board can be shared by different processes, satisfying the requirements of different PCB manufacturing processes. It effectively saves the circuit layout time. As the manpower and materials are efficiently used in the invention, the total cost is largely reduced.

The invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A manufacturing method of a multi-layer circuit board comprising the following steps:
(g) providing a conductive layer disposed on an insulation layer;
(h) patterning the conductive layer and forming at least one conductive layer opening;
(i) drilling a hole at the conductive layer opening through the insulation layer, thereby forming a via;
(j) introducing a conductive material in the via;
(k) forming a plurality of substrates by repeating steps (g) to (j); and
(l) bonding the substrates;
wherein at least one conductive layer opening located at the position along a normal direction to the board that is not perpendicular to its adjacent conductive layer opening.

2. The method of claim 1, wherein the bonding step is performed immediately after the substrate is formed or after all the substrates are formed.

3. The method of claim 1, wherein the drilling step involves laser drilling or mechanical drilling.

4. The method of claim 1, wherein the step of introducing a conductive material in the via is performed by electroplating or deposition.

5. A printed circuit board (PCB), comprising:
a center substrate having a center insulation layer connected to a center conductive layer, the center insulation layer having a center via; and
an additional substrate having an additional insulation layer and an additional conductive layer, the additional insulation layer being disposed between the center conductive layer and the additional conductive layer and having an additional via;
wherein the center via and the additional via are loaded with a conductive material, the axis of the center via and the axis of the additional via are separated by a predetermined distance and electrically coupled using the center conductive layer and the conductive material.

6. The PCB of claim 5, wherein the center substrate has a multi-layer substrate structure.

7. The PCB of claim 5, wherein the material of the insulation layer includes phenolic resin or epoxy resin.

8. The PCB of claim 5, wherein the conductive material is loaded in the center via and/or the additional via by electroplating or deposition.

9. A multi-layer PCB comprising:
a center substrate having a center insulation layer with a center via and disposed between a center conductive layer and a second center conductive layer;
a first additional substrate having a first additional insulation layer with a first additional via and disposed between the first center conductive layer and the first additional conductive layer; and
a second additional substrate having a second additional insulation layer with a second additional via and disposed between the second center conductive layer and the second additional conductive layer;
wherein the center via and the additional vias are loaded with a conductive material, the axis of the center via is separated from the axis of the second additional via by a predetermined distance and coincides with the axis of the first additional via along the normal to the board, and the center via and the additional vias are electrically coupled using the center conductive layer and the conductive material.

10. A portable electronic device comprising:
an input unit for entering an input signal;
a control unit, which includes:
a center substrate having a center insulation layer connected to a center conductive layer, the center insulation layer having a center via; and
an additional substrate having an additional insulation layer and an additional conductive layer, the additional insulation layer being disposed between the center conductive layer and the additional conductive layer and having an additional via;
wherein the center via and the additional via are loaded with a conductive material, the axis of the center via and the axis of the additional via are separated by a predetermined distance and are electrically coupled using the center conductive layer and the conductive material, and the input signal is transmitted between the substrates; and
a display unit, which responds with an image corresponding to the input signal.
